# EUROPÄISCHE PATENTSCHRIFT

(11) **EP 0 766 360 B1**
(45) Veröffentlichungstag und Bekanntmachung des Hinweises auf die Patenterteilung: **02.06.1999**
(21) Anmeldenummer: 96113510.0
(22) Anmeldetag: 23.08.1996
(51) Int. Cl.: H02B 1/46, H05K 5/02, E05D 7/10

(54) **Gehäuse**
Casing
Boîtier

(30) Priorität: 28.09.1995 DE 29515499 U
(43) Veröffentlichungstag der Anmeldung: 02.04.1997
(73) Patentinhaber: Endress + Hauser GmbH + Co., 79689 Maulburg (DE)
(72) Erfinder: Maier, Winfried, 79689 Maulburg (DE)
(74) Vertreter: Morstadt, Volker, Dipl.-Ing.

(56) Entgegenhaltungen:
- US-A- 2 734 222
- US-A- 4 731 903
- IBM TECHNICAL DISCLOSURE BULLETIN, Bd. 30, Nr. 11, 1.April 1988, Seite 370/371 XP000095649 "PLASTIC SNAP-IN HINGE"

## Beschreibung

Die Erfindung betrifft ein Gehäuse mit einem aufklappbaren Deckel, einem Gehäusetopf und einem den Deckel mit dem Gehäusetopf verbindenden Befestigungselement.

Gehäuse mit einem aufklappbaren Deckel und einem Gehäusetopf werden in einer Vielzahl von Anwendungen eingesetzt. Ein Beispiel einer Anwendung ist ein Gehäuse zur Aufnahme der Elektronik eines Meßgeräts, z.B. eines Druck-, Füllstands- oder Durchflußmeßgeräts. Solche Gehäuse weisen einen aufklappbaren Deckel auf, z.B. damit die Elektronik für eine Einstellung oder Parametrierung derselben am Meßort zugänglich ist. Ein Gehäuse mit einem aufklappbaren Deckel und einem Befestigungselement, das in eine Öffnung des Deckels eingesteckt ist, eine mit dem Deckel zu verbindende erste Halterung aufweist, in der Öffnung des Deckels durch einem der deckel-zugewandten Seite der ersten Halterung angeformte Widerhaken fixiert ist und eine zweite mit dem Gehäuse zu verbindende Halterung aufweist, welche eine Achse umfaßt, die in ein am Gehäuse angeformtes, durch zwei Lagerungen mit Lagerbohrungen, gebildetes Achslager einführbar ist, ist aus US-A-4 731 903 (KENNEDY ET AL.) bekannt.

Es ist eine Aufgabe der Erfindung, ein Gehäuse mit einem aufklappbaren Deckel und einem Gehäusetopf anzugeben, bei dem der Deckel mit dem Gehäusetopf durch ein einfach zu montierendes Befestigungselement verbunden ist und bei dem sich das Befestigungselement bei einer unsachgemäßen Öffnung des Deckels über einen vorgesehenen Öffnungswinkel hinaus von dem Gehäusetopf löst, ohne dabei zerstört zu werden.

Diese Aufgabe wird durch die im Schutzanspruch definierte Erfindung gelöst.

Die Erfindung und deren Vorteile werden nun anhand der Figuren der Zeichnung, in denen ein Ausführungsbeispiel dargestellt ist, näher erläutert; gleiche Elemente sind in den Figuren mit gleichen Bezugszeichen versehen.
Fig. 1 zeigt ein Gehäuse im Längsschnitt,
Fig. 2a zeigt das Befestigungselement im Querschnitt und
Fig. 2b zeigt das Befestigungselement im Längsschnitt.

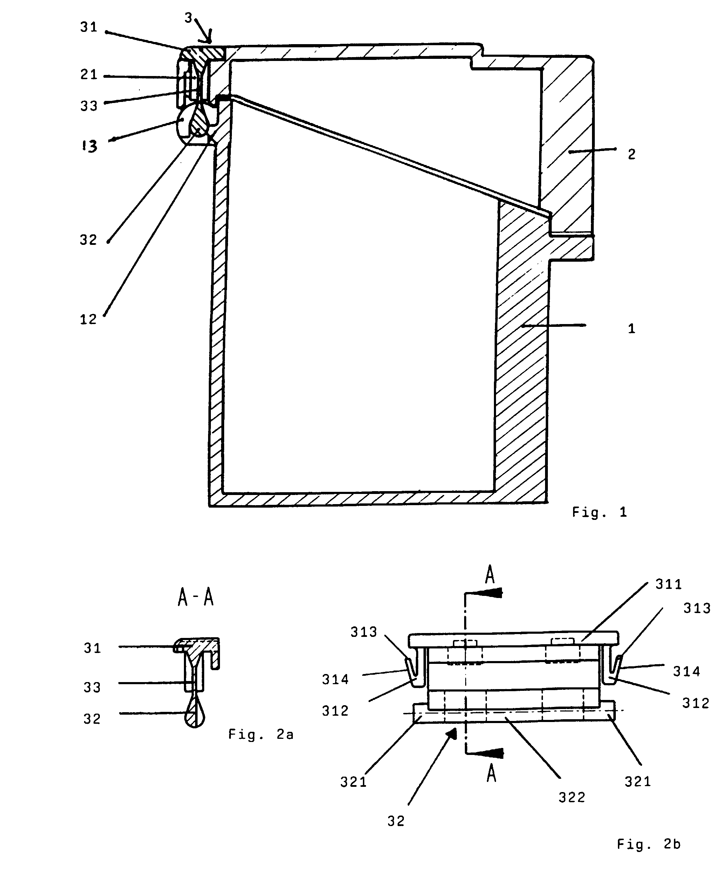

Fig. 1 zeigt ein Ausführungsbeispiel eines Gehäuses im Längsschnitt. Das Gehäuse besteht aus einem Gehäusetopf 1 und einem aufklappbaren Deckel 2.

Der Deckel 2 ist mit dem Gehäusetopf 1 durch ein in Fig. 2a und 2b im Detail dargestelltes Befestigungselement 3 verbunden. Das Befestigungselement 3 hat die Funktion eines Scharniers und weist eine erste und eine zweite Halterung 31, 32 auf. Mittels der ersten Halterung 31 ist das Befestigungselement 3 mit dem Deckel 2 und mittels der zweiten Halterung 32 mit dem Gehäusetopf 1 verbunden.

Die erste Halterung 31 besteht aus einem Balken 311 mit rechteckigem Querschnitt. An einer Grundfläche des Balkens 311 ist eine sich in einem rechten Winkel zur Grundfläche erstreckende Verbindungsplatte 33 angeformt. An das balkenabgewandte Ende der Verbindungsplatte 33 schließt die zweite Halterung 32 an.

Der Deckel 2 weist eine Öffnung 21 mit einem rechteckigen Querschnitt auf, der geringfügig kleiner ist als der Querschnitt des Balkens 311. In diese Öffnung 21 ist das Befestigungselement 3 einzustecken. Der Balken 311 liegt mit einer äußeren Randfläche der verbindungsplattenzugewandten Grundfläche auf dem Deckel 2 auf. Die Verbindungsplatte 33 und die zweite Halterung 32 ragen durch die Öffnung 21 auf der gehäusetopf-zugewandten Seite durch den Deckel 2 hindurch.

Das Befestigungselement 3 ist im Deckel 2 durch zwei endseitig an der Grundfläche des Balkens 311 angeformte, im wesentlichen U-förmige Widerhaken 312 fixiert. Diese werden beim Einstecken des Befestigungselements 3 in die Öffnung 21 zunächst zusammengedrückt und stützen sich dann mit deren freien Abstützflächen 313 gegen die Deckelinnenwand ab. Zur Erleichterung der Montage sind die Außenkanten 314 des Widerhakens 312 angeschrägt.

Die zweite Halterung 32 umfaßt eine an der Verbindungsplatte 33 angeforme Achse, die in ein auf der Gehäusetopf-Außenseite angeformtes Achslager einschnappbar ist.

Das Achslager besteht aus zwei voneinander beabstandet an der Gehäusetopf-Außenseite angeformten Lagerungen 13. Die Lagerungen 13 weisen Lagerbohrungen zur Aufnahme der zweiten Halterung 32 auf. Hierzu verlaufen die Lagerbohrungen 13 parallel zu einer nicht-dargestellten Verbindungslinie zwischen den beiden Lagerungen 13. Die Bohrungsöffnungen befinden sich jeweils auf der der gegenüberliegenden Lagerung 13 zugewandten Seite.
Weiterhin weisen die Lagerungen 13 jeweils eine weitere auf deren deckel-abgewandten Seite angeordnete Öffnung auf, durch die die Lagerbohrungen zugänglich sind. Zwischen den beiden Lagerungen 13 ist eine Rastnase 12 angeordnet.

Die zweite Halterung 32 ist über die Rastnase 12 zu schnappen und deren freie Enden 321 sind durch die Öffnungen in die Lagerbohrungen der Lagerungen 13 einzubringen. Die zweite Halterung 32 ist somit zwischen der Rastnase 12 und den Lagerungen 13 eingespannt. Die Innendurchmesser der Lagerbohrungen entsprechen dem Außendurchmesser der zweiten Halterung 32. Dadurch ist die zweite Halterung 32 bereits durch die Lagerbohrungen in deren Lage gehalten.

Die zweite Halterung 32 weist auf der gehäuse-zugewandten Seite eine abgerundete Schulter 322 auf, mit der das Befestigungselement 3 beim Öffnen des Deckels 2 auf der Rastnase 12 abrollt.

Zwischen der Schulter 322 und den freien Enden 321 weist die zweite Halterung 32, also die Achse, jeweils einen Abschnitt mit einem halbkreisförmigen Querschnitt auf.
Die zweite Halterung 32 ist biege-elastisch. Beim Öffnen des Deckels 2 über einen vorgesehenen Öffnungswinkel hinaus erfährt sie eine Durchbiegung quer zu deren Längsachse. Dabei sind die freien Enden 321 der zweiten Halterung 32 zunächst in den Lagerbohrungen fixiert. Mit zunehmendem Öffnungswinkel des Deckels 2 nimmt die Durchbiegung der zweiten Halterung 32 jedoch zu, bis sie unbeschädigt aus dem Achslager herausgleitet.

Die Biege-Elastizität der zweiten Halterung 32 wird durch deren Abschnitte mit halbkreisförmigem Querschnitt zusätzlich erhöht. Weiterhin ist die Verbindungsplatte 33 entsprechend dünn und biege-elastisch ausgebildet.

Das Befestigungselement 3 besteht vorzugsweise aus einem Kunststoff. Besonders gut geeignet ist ein zugfester, stabiler, zäher, elastischer, kostengünstiger und wetterfester Werkstoff, insb. Polyphenylenether (PPE).

Das Befestigungselement 3, also die Verbindung zwischen dem Gehäusetopf 1 und dem Deckel 2, ist durch unsachgemäße Behandlung praktisch nicht zu zerstören. Bei einer ruckartigen Belastung des Befestigungselements 3 springt es aus der Einspannung im Achslager heraus, und bei einer Öffnung des Deckels über einen vorgesehenen Öffnungswinkel hinaus erfährt die zweite Halterung 32 eine Durchbiegung und gleitet aus den Lagerbohrungen heraus.

Der Deckel 2 ist mit einem einzigen Handgriff mit der zweiten Halterung 32 sofort wieder in dem Achslager einzuspannen.

## Patentansprüche

1. Gehäuse mit
- einem Gehäusetopf (1),
- einem aufklappbaren Deckel (2) und
- einem Befestigungselement (3), , das
-- in eine Öffnung (21) des Deckels (2) eingesteckt ist,
-- eine mit dem Deckel (2) zu verbindende erste Halterung (31), insb. einen Balken mit rechteckigem Querschnitt, aufweist,
-- in der Öffnung (21) des Deckels (2) durch zwei endseitig auf der deckel-zugewandten Seite der ersten Halterung (31) angeformte Widerhaken (312) fixiert ist und
-- eine zweite mit dem Gehäusetopf (1) zu verbindende Halterung (32) aufweist,
--- welche eine Achse umfaßt, die in ein am Gehäusetopf (1) angeformtes, durch zwei Lagerungen (13) mit Lagerbohrungen, zwei jeweils auf der deckelabgewandten Seite der Lagerungen (13) angeordneten Öffnungen, durch die die Lagerbohrungen zugänglich sind, und eine zwischen den Lagerungen (13) angeordnete Rastnase (12) gebildetes Achslager einschnappbar ist,
---- wobei die Achse (32) biege-elastisch ist und beim Öffnen des Deckels (2) über einen vorgesehenen Öffnungswinkel hinaus eine Durchbiegung erfährt, durch die sie unbeschädigt aus dem Achslager herausgleitet, und
--- welche zweite Halterung (32) auf der gehäusezugewandten Seite eine abgerundete Schulter (322) aufweist, mit der das Befestigungselement (3) beim Öffnen des Deckels (2) auf der Rastnase (12) abrollt.

## Claims

1. Housing having
- a pot-like housing base (1),
- a swing-open cover (2) and
- a fastening element (3) which
-- is inserted into an opening (21) of the cover (2),
-- has a first securing means (31), which is to be connected to the cover (2), in particular a bar of rectangular cross section,
-- is fixed in the opening (21) of the cover (2) by two barbs (312), which are integrally formed at the ends of that side of the first securing means (31) which is directed towards the cover, and
-- has a second securing means (32), which is to be connected to the pot-like housing base (1),
--- which second securing means (32) comprises a stub which can be snapped into a stub bearing which is integrally formed on the pot-like housing base (1) and is formed by two mounts (13) with bearing bores, two openings through which the bearing bores are accessible and which are each arranged on that side of the mounts (13) which is directed away from the cover, and a latching nose (12) arranged between the mounts (13),
---- it being the case that the stub (32) is flexurally elastic and, when the cover (2) is opened beyond an envisaged opening angle, undergoes a bending action, by virtue of which it slides out of the stub bearing without being damaged, and
--- which second securing means (32), on the side which is directed towards the housing, has a rounded shoulder (322), by way of which the fastening element (3) rolls on the latching nose (12) when the cover (2) is opened.

## Revendications

1. Boîtier, comprenant
- une cuve de boîtier (1),
- un couvercle rabattable (2) et
- un élément de fixation (3), qui
-- est inséré dans une ouverture (21) du couvercle (2),
-- présente une première attache (31) à relier au couvercle (2), notamment un étrier de section rectangulaire,
-- est fixé dans l'ouverture (21) du couvercle (2) à l'aide de deux barbes (312) disposées aux extrémités de la face opposée au couvercle de la première attache (31), et
-- présente une seconde attache (32) à relier à la cuve de boîtier (1),
--- qui présente un axe qui est encliquetable dans un palier solidaire de la cuve de boîtier (1) et qui est constitué par deux logements de palier (13) présentant des alésages de palier, par deux ouvertures disposées respectivement sur la face tournant le dos aux logements de palier (13), à travers lesquelles les alésages sont accessibles, et par un nez d'encliquetage (12) disposé entré les logements de palier (13),
--- l'axe (32) étant flexible et subit une flèche lors de l'ouverture du couvercle (2) au-delà d'un angle d'ouverture prévu, lui permettant de glisser sans encombres hors du palier, et
--- laquelle seconde attache (32), sur le côté opposé au boîtier, présente un épaulement (322) arrondi, par lequel l'élément de fixation (3) se déroule sur le nez d'encliquetage (12) lors de l'ouverture du couvercle (2).
